# EUROPEAN PATENT APPLICATION

(11) **EP 4 513 897 A1**
(43) Date of publication of application: **26.02.2025**
(21) Application number: 23791534.3
(22) Date of filing: 27.02.2023
(51) Int. Cl.: H04R 17/00, H04R 31/00

(54) **ULTRASONIC TRANSDUCER AND METHOD FOR PRODUCING SAME**

(30) Priority: 19.04.2022 JP 2022068729
(71) Applicant: Murata Manufacturing Co., Ltd., Nagaokakyo-shi, Kyoto 617-8555 (JP)
(72) Inventor: MATSUSHITA, Tomoaki, Nagaokakyo-shi, Kyoto 617-8555 (JP); SHIMAMOTO, Takayuki, Nagaokakyo-shi, Kyoto 617-8555 (JP)
(74) Representative: Reddie & Grose LLP
(86) International application number: PCT/JP2023/007065
(87) International publication number: WO 2023/203879

(57) **Abstract**

A flexible printed circuit board (140) includes a first surface section (141), a second surface section (142), and a third surface section (143). The first surface section (141) has a first electrode (145) electrically connected to a piezoelectric element (120), and extends in contact with a first main surface (121) of the piezoelectric element (120). The second surface section (142) is bent from an end of the first surface section (141) closer to a side wall (112) of a case (110), and extends upward along the side wall (112). The third surface section (143) has a second electrode (146) electrically connected to a first end (131) of a terminal member (130), and is bent in an S-shape from an upper end of the second surface section (142) so as to face the first surface section (141) with an interval interposed therebetween. The first surface section (141) and at least a portion of the second surface section (142) closer to the first surface section (141) are embedded in a first filling material (150).

## Description

### TECHNICAL FIELD

The present invention relates to an ultrasonic transducer and a method of manufacturing the same.

### BACKGROUND ART

As a prior art document, WO 2013/051525 (PTL 1) describes an ultrasonic sensor. The ultrasonic sensor described in PTL 1 includes a case, a piezoelectric element, a pin terminal, a strip-shaped flexible board, and a damping material. The case includes a bottom plate and a side wall. The piezoelectric element is disposed on the bottom plate inside the case. One tip end of the pin terminal is disposed in the opening of the case, and the other tip end thereof is disposed outside the case. The flexible board includes a first end connected to one tip end of the pin terminal and a second end connected to the piezoelectric element. The damping material seals one tip end of the pin terminal and the flexible board in the case.

### CITATION LIST

### PATENT LITERATURE

PTL 1: WO 2013/051525

### SUMMARY OF INVENTION

### TECHNICAL PROBLEM

In the ultrasonic sensor described in PTL 1, a portion of the flexible printed circuit board closer to the piezoelectric element is disposed directly above the piezoelectric element. In this case, the portion of the flexible printed circuit board may prevent the filling material filled in the case from absorbing an ultrasonic vibration oscillated from the piezoelectric element. Therefore, there is a room for improving the acoustic characteristics of the ultrasonic sensor by allowing the filling material to fully absorb the ultrasonic vibration.

The present invention has been made in view of the aforementioned problems, and an object of the present invention is to provide an ultrasonic transducer which has improved acoustic characteristics by allowing a filling material to fully absorb an ultrasonic vibration, and a method of manufacturing the same.

### SOLUTION TO PROBLEM

An ultrasonic transducer according to the present invention includes a cylindrical case, a piezoelectric element, a terminal member, a strip-shaped flexible printed circuit board, a first filling material, and a second filling material. The case has a bottom and a side wall. The piezoelectric element has a first main surface and a second main surface, and the second main surface is attached to the bottom inside the case. The terminal member has a first end disposed inside the case and a second end disposed outside the case. The flexible printed circuit board electrically connects the piezoelectric element and the first end of the terminal member. The first filling material is filled in the case so as to cover the bottom. The second filling material is filled in the case so as to cover the first filling material. The flexible printed circuit board includes a first surface section, a second surface section, and a third surface section. The first surface section includes a first electrode electrically connected to the piezoelectric element, and extends in contact with the first main surface of the piezoelectric element. The second surface section is bent from an end of the first surface section closer to the side wall of the case, and extends upward along the side wall. The third surface section includes a second electrode electrically connected to the first end of the terminal member, and is bent in an S-shape from an upper end of the second surface section so as to face the first surface section with an interval interposed therebetween. The first surface section and at least a portion of the second surface section closer to the first surface section are embedded in the first filling material.

### ADVANTAGEOUS EFFECTS OF INVENTION

According to the present invention, the acoustic characteristics of the ultrasonic transducer can be improved by allowing the filling material to fully absorb the ultrasonic vibration.

### BRIEF DESCRIPTION OF DRAWINGS

Fig. 1 is a longitudinal cross-sectional view of an ultrasonic transducer according to a first embodiment of the present invention;
Fig. 2 is a flowchart illustrating a method of manufacturing the ultrasonic transducer according to the first embodiment of the present invention;
Fig. 3 is a cross-sectional view illustrating a state in which a piezoelectric element and a flexible printed circuit board included in the ultrasonic transducer according to the first embodiment of the present invention are connected to each other;
Fig. 4 is a longitudinal cross-sectional view illustrating a state in which a piezoelectric element included in the ultrasonic transducer according to the first embodiment of the present invention is attached to a bottom of a case;
Fig. 5 is a longitudinal cross-sectional view illustrating a state in which a first filling material included in the ultrasonic transducer according to the first embodiment of the present invention is filled in the case;
Fig. 6 is a longitudinal cross-sectional view illustrating a state in which a terminal member included in the ultrasonic transducer according to the first embodiment of the present invention is connected to the flexible printed circuit board;
Fig. 7 is a longitudinal cross-sectional view illustrating a state in which the first end of the terminal member is disposed inside the case by bending the flexible printed circuit board included in the ultrasonic transducer according to the first embodiment of the present invention; and
Fig. 8 is a longitudinal cross-sectional view of an ultrasonic transducer according to a second embodiment of the present invention.

### DESCRIPTION OF EMBODIMENTS

Hereinafter, an ultrasonic transducer according to each embodiment of the present invention will be described with reference to the drawings. In the following description of each embodiment, the same or corresponding parts in the drawings are denoted by the same reference numerals, and the description thereof will not be repeated.

In the drawings, a direction along a bottom of a case is defined as a DR1 direction, and a direction along a height of the case is defined as a DR2 direction.

### (First Embodiment)

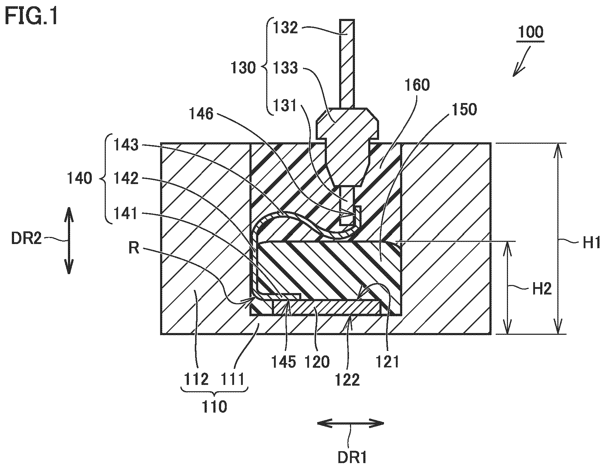

Fig. 1 is a longitudinal cross-sectional view of an ultrasonic transducer according to a first embodiment of the present invention. As illustrated in Fig. 1, an ultrasonic transducer 100 according to the present embodiment is, for example, an ultrasonic sensor.

As illustrated in Fig. 1, the ultrasonic transducer 100 includes a cylindrical case 110, a piezoelectric element 120, a terminal member 130, a strip-shaped flexible printed circuit board 140, a first filling material 150, and a second filling material 160.

The case 110 has a bottom 111 and a side wall 112. The bottom 111 of the present embodiment has a disc shape when viewed from the DR2 direction. The diameter of the bottom 111 is, for example, 14.0 mm or more and 15.5 mm or less. Note that the shape of the bottom 111 is not limited to a disc shape, and may be a rectangular shape, a polygonal shape, or the like.

The side wall 112 extends upward from the peripheral edge of the bottom 111. A height H1 of the case 110 from an outer bottom surface of the bottom 111 located outside the case 110 to an upper end of the side wall 112 is, for example, 9.0 mm.

The case 110 is made of a conductive material. In the present embodiment, the case 110 is made of, for example, an aluminum alloy. However, the material of the case 110 is not limited to a conductive material, and may be an insulating material. The case 110 is formed by, for example, forging.

The piezoelectric element 120 includes, for example, a piezoelectric body made of ceramics. In the present embodiment, the piezoelectric body of the piezoelectric element 120 is made of PZT (lead zirconate titanate) -based ceramics. However, the piezoelectric body of the piezoelectric element 120 is not limited to the PZT-based ceramics, and may be the other piezoelectric materials.

The piezoelectric element 120 is attached to the bottom 111 to form a unimorph piezoelectric vibrator. The piezoelectric element 120 may be a bimorph piezoelectric vibrator or a multimorph piezoelectric vibrator.

The piezoelectric element 120 is provided with a pair of electrodes (not shown). When a voltage is applied to the pair of electrodes, the piezoelectric element 120 is driven to vibrate. When the piezoelectric element 120 vibrates, the bottom 111 vibrates accordingly.

When the bottom 111 of the case 110 is vibrated by an ultrasonic wave received from the outside, the piezoelectric element 120 also vibrates in response to the vibration. The piezoelectric element 120 generates an electric charge in response to the vibration, and thereby the piezoelectric element 120 converts the ultrasonic wave into an electrical signal. The electrical signal is transmitted to the outside through the pair of electrodes.

As illustrated in Fig. 1, in the ultrasonic transducer 100 according to the present embodiment, the piezoelectric element 120 is disposed at a substantially central position of the case 110 in the DR1 direction.

The piezoelectric element 120 includes a first main surface 121 and a second main surface 122. The first main surface 121 and the second main surface 122 face each other. The second main surface 122 is attached to the bottom 111 inside the case 110. In the present embodiment, the piezoelectric element 120 is bonded to the bottom 111 by epoxy resin.

In the DR1 direction, the ratio of the width of an inner space of the case 110 to the width of the piezoelectric element 120 is 1.1 or more. Owing to this ratio, the piezoelectric element 120 can be attached to the bottom 111 of the case 110 without applying an overload to the flexible printed circuit board 140 to be described later.

The terminal member 130 in the present embodiment is a pin terminal. The terminal member 130 includes a first end 131, a second end 132, and a support member 133.

The first end 131 is disposed inside the case 110. The second end 132 is disposed outside the case 110. The support member 133 supports the first end 131 and the second end 132. Each of the first end 131, the second end 132, and the support member 133 is made of a conductive material.

The flexible printed circuit board 140 electrically connects the piezoelectric element 120 and the first end 131 of the terminal member 130. The flexible printed circuit board 140 is provided with an electric wiring for applying a voltage to the piezoelectric element 120, a signal line for transmitting an electric signal generated by the piezoelectric element 120, and the like.

The flexible printed circuit board 140 includes a first surface section 141, a second surface section 142, and a third surface section 143.

The first surface section 141 extends in contact with the first main surface 121 of the piezoelectric element 120. The first surface section 141 extends along the DR1 direction.

The first surface section 141 includes a first electrode 145 electrically connected to the piezoelectric element 120. The first electrode 145 is connected to the first main surface 121 of the piezoelectric element 120 by soldering, for example.

The second surface section 142 is bent from an end of the first surface section 141 closer to the side wall 112 of the case 110, and extends upward along the side wall 112. In the present embodiment, the second surface section 142 is in direct contact with the side wall 112. The second surface section 142 may extend along the side wall 112 with a gap from the side wall 112. Although the second surface section 142 in the present embodiment is mainly formed in a linear shape, it may be curved in such a manner that the piezoelectric element 120 and the second surface section 142 are not aligned with each other in the DR2 direction.

In the present embodiment, since a portion of the flexible printed circuit board 140 closer to the piezoelectric element 120 is linearly fixed in the case 110, it is possible to easily determine the position of the flexible printed circuit board 140. As a result, it is possible to prevent variations from occurring in the position of the first filling material 150 that fills the portion of the flexible printed circuit board 140, which will be described later. As a result, it is possible to prevent variations from occurring in the sound absorption characteristics of the first filling material 150 that absorbs the ultrasonic vibration oscillated from the piezoelectric element 120, which makes it possible to prevent variations from occurring in the acoustic characteristics of the ultrasonic transducer 100 with respect to the ultrasonic vibration.

In the flexible printed circuit board 140, the curvature R of a curved portion of the second surface section 142 located at a boundary with the end of the first surface section 141 is 0.8 (1/mm) or more and 2.9 (1/mm) or less. As a result, it is possible to prevent an overload from being applied to the portion located at the boundary between the first surface section 141 and the second surface section 142, and allow the second surface section 142 to extend in directly contact with the side wall 112.

The third surface section 143 is bent in an S-shape from the upper end of the second surface section 142 and faces the first surface section 141 with an interval interposed therebetween. The third surface section 143 is bent in an S-shape along the DR1 direction. The third surface section 143 is not limited to an S-shape, and may be a linear shape, a meandering shape, or the like in the DR1 direction.

The third surface section 143 includes a second electrode 146 electrically connected to the first end 131 of the terminal member 130. The second electrode 146 is connected to the first end 131 of the terminal member 130 by soldering, for example.

The first electrode 145 and the second electrode 146 are disposed on either a front surface or a back surface of the flexible printed circuit board 140. In the present embodiment, when a surface of the flexible printed circuit board 140 that is connected to the piezoelectric element 120 and the first end 131 of the terminal member 130 is defined as a front surface, the first electrode 145 and the second electrode 146 are disposed on the front surface.

When disposing the first electrode 145 and the second electrode 146 on the flexible printed circuit board 140, if the first electrode 145 and the second electrode 146 are disposed on the front surface and the back surface of the flexible printed circuit board 140, respectively, the manufacturing process of disposing the first electrode 145 and the second electrode 146 on the flexible printed circuit board 140 includes a plurality of steps. Thus, the manufacturing process becomes complicated and the manufacturing cost increases. On the other hand, if the first electrode 145 and the second electrode 146 are disposed on either the front surface or the back surface of the flexible printed circuit board 140, the manufacturing process of disposing the first electrode 145 and the second electrode 146 on the flexible printed circuit board 140 includes only one step, which makes it possible to manufacture the flexible printed circuit board 140 cheaply.

The first filling material 150 is filled in the case 110 so as to cover the bottom 111. The piezoelectric element 120 and a portion of the flexible printed circuit board 140 are embedded in the first filling material 150. Specifically, in the flexible printed circuit board 140, the first surface section 141 and at least a portion of the second surface section 142 closer to the first surface section 141 are embedded in the first filling material 150.

The first filling material 150 is made of foamed silicone resin. The first filling material 150 is formed by curing liquid silicone resin.

The first filling material 150 has a height H2 from an outer bottom surface of the bottom 111 located outside the case 110 to an upper end of the first filling material 150. The ratio of the height H2 of the first filling material 150 to the height H1 of the case 110 in the height direction (DR2 direction) orthogonal to the bottom 111 is 0.3 or more and 0.7 or less. Accordingly, it is possible to ensure a space to dispose the first end 131 of the terminal member 130 in the case 110, and it is possible to prevent the sound absorption characteristics of the first filling material 150 that absorbs the ultrasonic vibration from decreasing.

The second filling material 160 is filled in the case 110 so as to cover the first filling material 150. The second filling material 160 is made of silicone resin. The second filling material 160 may be made of a resin material such as urethane-based resin.

Hereinafter, a method of manufacturing the ultrasonic transducer 100 according to the first embodiment of the present invention will be described.

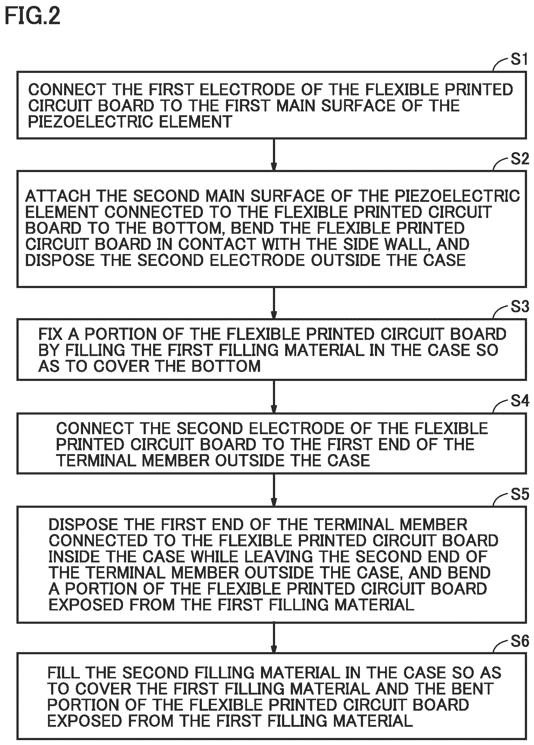

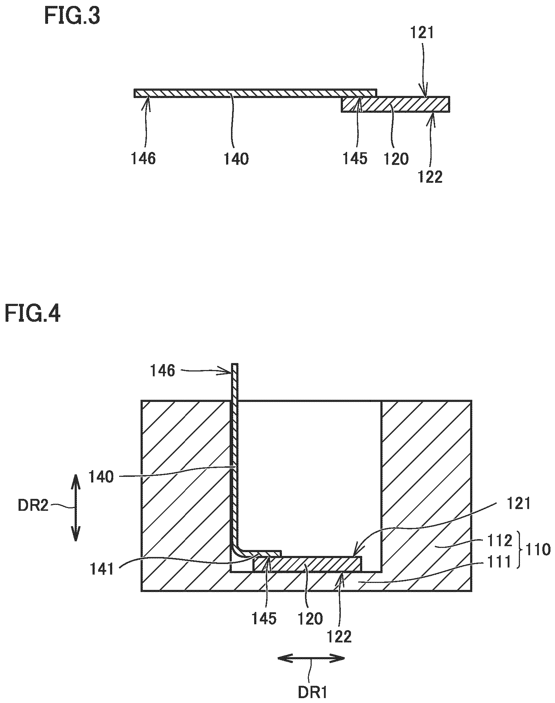

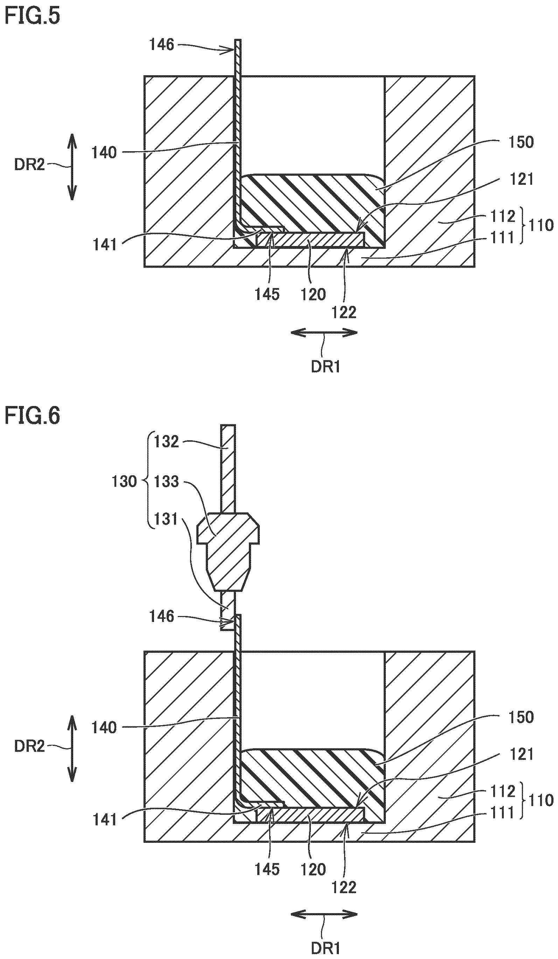

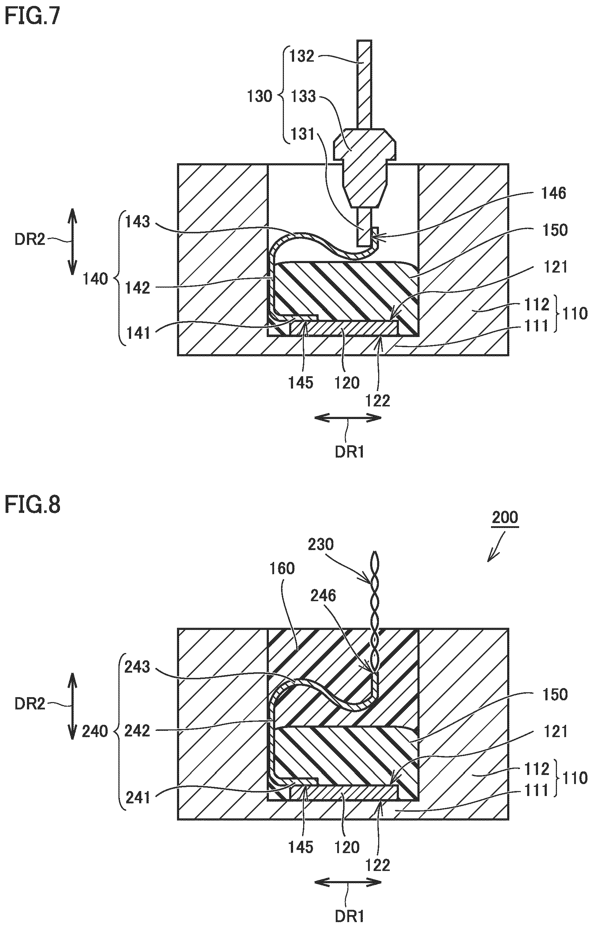

Fig. 2 is a flowchart illustrating a method of manufacturing the ultrasonic transducer according to the first embodiment of the present invention. Fig. 3 is a cross-sectional view illustrating a state in which a piezoelectric element and a flexible printed circuit board included in the ultrasonic transducer according to the first embodiment of the present invention are connected to each other. Fig. 4 is a longitudinal cross-sectional view illustrating a state in which a piezoelectric element included in the ultrasonic transducer according to the first embodiment of the present invention is attached to a bottom of a case. Fig. 5 is a longitudinal cross-sectional view illustrating a state in which a first filling material included in the ultrasonic transducer according to the first embodiment of the present invention is filled in the case. Fig. 6 is a longitudinal cross-sectional view illustrating a state in which a terminal member included in the ultrasonic transducer according to the first embodiment of the present invention is connected to the flexible printed circuit board. Fig. 7 is a longitudinal cross-sectional view illustrating a state in which the first end of the terminal member is disposed inside the case by bending the flexible printed circuit board included in the ultrasonic transducer according to the first embodiment of the present invention.

As illustrated in Figs. 2 and 3, in the method of manufacturing the ultrasonic transducer 100, first, the first electrode 145 of the flexible printed circuit board 140 is connected to the first main surface 121 of the piezoelectric element 120 (step S1).

Next, as illustrated in Figs. 2 and 4, the second main surface 122 of the piezoelectric element 120 connected to the flexible printed circuit board 140 is attached to the bottom 111, the flexible printed circuit board 140 is bent and brought into contact with the side wall 112, and the second electrode 146 is disposed outside the case 110 (step S2). Thus, the first surface section 141 is formed in the flexible printed circuit board 140.

Since the flexible printed circuit board 140 is bent and brought into contact with the side wall 112, the side wall 112 can support the flexible printed circuit board 140, which prevents variations from occurring in the position of the second electrode 146 of the flexible printed circuit board 140. Specifically, the accuracy of the position of the second electrode 146 can be controlled to ±0.2 mm or less with respect to the designed position. Accordingly, when connecting the flexible printed circuit board 140 and the terminal member 130 to each other, which will be described later, it is possible to prevent variations from occurring in the connection position therebetween, which makes it possible to automate the connection between the flexible printed circuit board 140 and the terminal member 130 by using an automated apparatus.

Next, as illustrated in Figs. 2 and 5, a portion of the flexible printed circuit board 140 is fixed by filling the first filling material 150 in the case 110 so as to cover the bottom 111 (step S3).

The first filling material 150 may be formed by potting. In the potting, a liquid silicone resin is applied to each of the piezoelectric element 120 and the flexible printed circuit board 140 in the case 110, and then the liquid silicone resin is cured. Thus, regardless of the shape of the piezoelectric element 120 and the shape of the flexible printed circuit board 140, the first filling material 150 can be provided in close contact with the piezoelectric element 120 and the flexible printed circuit board 140.

Next, as illustrated in Figs. 2 and 6, the second electrode 146 of the flexible printed circuit board 140 is connected to the first end 131 of the terminal member 130 outside the case 110 (step S4). Since a portion of the flexible printed circuit board 140 is fixed by the first filling material 150, the entire flexible printed circuit board 140 is prevented from distorting. If the piezoelectric element 120 and the first end 131 of the terminal member 130 are connected to the front surface of the flexible printed circuit board 140, the first end 131 may be connected to the back surface of the flexible printed circuit board 140.

When connecting the second electrode 146 to the first end 131, since a portion of the flexible printed circuit board 140 linearly extends to the outside of the case 110 along the side wall 112, a space is secured without any obstacle around the second electrode 146. When the second electrode 146 and the first end 131 are soldered to each other by an automated apparatus, the terminal member 130 and the flexible printed circuit board 140 are prevented from interfering with the components of the automated apparatus, and thus the connection between the second electrode 146 and the first end 131 can be automated.

Next, as illustrated in Figs. 2 and 7, the first end 131 of the terminal member 130 connected to the flexible printed circuit board 140 is disposed inside the case 110 while leaving the second end 132 of the terminal member 130 outside the case 110, and a portion of the flexible printed circuit board 140 exposed from the first filling material 150 is bent (step S5).

By filling the first filling material 150 to fix a portion of the flexible printed circuit board 140, a portion of the flexible printed circuit board 140 exposed from the first filling material 150 may be bent while maintaining the shape of the portion of the flexible printed circuit board 140 embedded in the first filler 150. As a result, the second surface section 142 and the third surface section 143 are formed in the flexible printed circuit board 140.

Next, as illustrated in Figs. 1 and 2, the second filling material 160 is filled in the case 110 so as to cover the first filling material 150 and the bent portion of the flexible printed circuit board 140 exposed from the first filling material 150 (step S6). The ultrasonic transducer 100 can be manufactured by the steps described above.

### (Experimental Example)

Hereinafter, a first experimental example will be described in which the relationship between the ratio of the height H2 of the first filling material 150 to the height H1 of the case 110 and the determination result of whether or not the piezoelectric element 120 and the flexible printed circuit board 140 are properly arranged in the case 110 is verified. As an experimental condition, when the ratio of the height H2 of the first filling material 150 to the height H1 of the case 110 was changed, whether or not the piezoelectric element 120 and the flexible printed circuit board 140 can be properly arranged in the case 110 was verified.

Table 1 summarizes the relationship between the ratio of the height H2 of the first filling material 150 to the height H1 of the case 110 and the determination result of whether or not the piezoelectric element 120 and the flexible printed circuit board 140 are properly arranged in the case 110 based on the results of the first experimental example.

**[Table 1]**

| Conditions | 1 | 2 | 3 | 4 | 5 |
|---|---|---|---|---|---|
| Ratio of height of first filling material to height of case | 0.2 | 0.3 | 0.6 | 0.7 | 0.8 |
| Arrangement result of piezoelectric element and flexible PCB | bad | good | good | good | bad |

As seen from Table 1, when the ratio was 0.3 or more and 0.7 or less, the piezoelectric element 120 and the flexible printed circuit board 140 can be properly arranged inside the case 110.

On the other hand, when the ratio was 0.2, although a portion of the flexible printed circuit board 140 could be fixed by the first filling material 150, the sound absorption characteristic of the first filling material 150 decreased, and the reverberation vibration became longer. As a result, the short-range detection performance of the ultrasonic transducer 100 when it is used as an ultrasonic sensor became worse.

When the ratio was 0.8, there is no sufficient space inside the case 110 when the flexible printed circuit board 140 is bent and arranged in the case 110, and thereby the entire flexible printed circuit board 140 cannot be accommodated in the case 110. The ratio may be determined, for example, by measuring the ultrasonic transducer cut in a longitudinal section with an optical microscope or the like.

Hereinafter, a second experimental example will be described in which the relationship between the curvature R of the boundary between the first surface section 141 and the second surface section 142 in the flexible printed circuit board 140 and the determination result of whether or not the flexible printed circuit board 140 is properly arranged is verified. As an experimental condition, when the curvature R was changed, whether or not the flexible printed circuit board 140 can be properly arranged in the case 110 was verified.

Table 2 summarizes the relationship between the curvature R of the boundary between the first surface section 141 and the second surface section 142 of the flexible printed circuit board 140 and determination result of whether or not the flexible printed circuit board 140 is properly arranged based on the results of the second experimental example.

**[Table 2]**

| Conditions | 1 | 2 | 3 | 4 | 5 |
|---|---|---|---|---|---|
| Curvature (1/mm) | 5.0 | 2.9 | 1.1 | 0.8 | 0.7 |
| Arrangement result of flexible PCB | bad | good | good | good | bad |

As seen from Table 2, when the curvature R was 0.8 (1/mm) or more and 2.9 (1/mm) or less, the flexible printed circuit board 140 could be properly arranged in the case 110.

On the other hand, when the curvature R was 0.7, the flexible printed circuit board 140 becomes inclined in the case 110, which makes it impossible to arrange the flexible printed circuit board 140 along the side wall 112. Therefore, the flexible printed circuit board 140 cannot be specifically positioned in the case 110, and thereby the connection between the second electrode 146 and the first end 131 cannot be automated.

When the curvature R was 5.0, due to the bending of the flexible printed circuit board 140, a stress was generated from the first surface section 141 and concentrated on the piezoelectric element 120. As a result, a conduction failure occurred between the piezoelectric element 120 and the flexible printed circuit board 140. The curvature R may be determined, for example, by measuring the ultrasonic transducer cut in a longitudinal section with an optical microscope or the like.

In the ultrasonic transducer 100 according to the first embodiment of the present invention, since the second surface section 142 of the flexible printed circuit board 140 is bent from an end of the first surface section 141 closer to the side wall 112 of the case 110 and extends upward along the side wall 112, it is possible to increase the proportion of the first filling material 150 disposed directly above the piezoelectric element 120, which makes it possible for the first filling material 150 to absorb the ultrasonic vibration oscillated from the piezoelectric element 120. Thus, the sound absorption characteristics of the first filling material 150 can be fully exhibited, and accordingly the acoustic characteristics of the ultrasonic transducer 100 can be improved.

In the ultrasonic transducer 100 according to the first embodiment of the present invention, since the second surface section 142 is fixed by the first filling material 150 while extending along the side wall 112, it is possible to prevent variations from occurring in the position of a portion of the flexible printed circuit board 140 closer to the piezoelectric element 120. Therefore, it is possible to prevent variations from occurring in the position of the first filling material 150 that covers a portion of the flexible printed circuit board 140 closer to the piezoelectric element 120. As a result, it is possible to prevent variations from occurring in the sound absorption characteristics of the first filling material 150.

In the ultrasonic transducer 100 according to the first embodiment of the present invention, since the second surface section 142 is in direct contact with the side wall 112, it is easier to position the flexible printed circuit board 140 in the case 110, which makes it possible to prevent variations from occurring in the sound absorption characteristics of the first filling material 150. Therefore, it is possible to prevent variations from occurring in the position of the first filling material 150 that covers a portion of the flexible printed circuit board 140 closer to the piezoelectric element 120. As a result, it is possible to prevent variations from occurring in the sound absorption characteristics of the first filling material 150.

In the ultrasonic transducer 100 according to the first embodiment of the present invention, since the first electrode 145 and the second electrode 146 are disposed on either the front surface or the back surface of the flexible printed circuit board 140, it is possible to form the first electrode 145 and the second electrode 146 on the flexible printed circuit board 140 in the same step, which makes it possible to simplify the manufacturing process of the flexible printed circuit board 140 and manufacture the flexible printed circuit board 140 cheaply.

In the ultrasonic transducer 100 according to the first embodiment of the present invention, since the ratio of the height H2 of the first filling material 150 to the height H1 of the case 110 in the height direction (DR2 direction) orthogonal to the bottom 111 is set to 0.3 or more and 0.7 or less, it is possible to accommodate the first end 131 in the case 110 while maintaining the sound absorption characteristics of the first filling material 150.

In the ultrasonic transducer 100 according to the first embodiment of the present invention, since the curvature R of a curved portion of the second surface section 142 located at the boundary with the end of the first surface section 141 in the flexible printed circuit board 140 is set to 0.8 (1/mm) or more and 2.9 (1/mm) or less, it is possible to prevent an overload from being applied to the flexible printed circuit board 140 when bending the same, and it is possible to erect the flexible printed circuit board 140 in the case 110.

In the method of manufacturing the ultrasonic transducer 100 according to the first embodiment of the present invention, since a portion of the flexible printed circuit board 140 closer to the piezoelectric element 120 is fixed by the first filling material 150 while extending along the side wall 112 and the second electrode 146 is disposed outside the case 110, the second electrode 146 and the first end 131 can be connected with a space secured around the second electrode 146. Accordingly, it is possible to prevent the terminal member 130 and the flexible printed circuit board 140 from interfering with the components of the automated apparatus, which makes it possible to automate the connection between the second electrode 146 and the first end 131. Thus, the connection between the terminal member 130 and the flexible printed circuit board 140 can be automated, whereby the ultrasonic transducer 100 can be manufactured efficiently.

### (Second Embodiment)

Hereinafter, an ultrasonic transducer according to a second embodiment of the present invention will be described with reference to the drawings. Since the ultrasonic transducer according to the second embodiment of the present invention differs from the ultrasonic transducer 100 according to the first embodiment of the present invention in the configuration of the terminal member, the description of the same components as the ultrasonic transducer 100 according to the first embodiment of the present invention will not be repeated.

Fig. 8 is a longitudinal cross-sectional view of the ultrasonic transducer according to the second embodiment of the present invention. As illustrated in Fig. 8, the ultrasonic transducer 200 according to the second embodiment of the present invention includes a cylindrical case 110, a piezoelectric element 120, a terminal member 230, a strip-shaped flexible printed circuit board 240, a first filling material 150, and a second filling material 160. The terminal member 230 in the present embodiment is a lead terminal.

The flexible printed circuit board 240 includes a first surface section 241, a second surface section 242, and a third surface section 243.

The third surface section 243 includes a second electrode 246 electrically connected to the terminal member 230. The second electrode 246 is connected to the terminal member 230 by soldering, for example.

In the ultrasonic transducer 200 according to the second embodiment of the present invention, since the second surface section 242 of the flexible printed circuit board 240 is bent from the end of the first surface section 241 closer to the side wall 112 of the case 110 and extends upward along the side wall 112, it is possible to increase the proportion of the first filling material 150 disposed directly above the piezoelectric element 120, which makes it possible for the first filling material 150 to absorb the ultrasonic vibration oscillated from the piezoelectric element 120. Thus, the sound absorption characteristics of the first filling material 150 can be fully exhibited.

In the ultrasonic transducer 200 according to the second embodiment of the present invention, since the terminal member 230 is a lead terminal, it is possible to improve the degree of freedom of bending the third surface section 243 of the flexible printed circuit board 240 as compared with the case where the terminal member is a pin terminal.

### [Aspects]

### Aspect <1>

An ultrasonic transducer comprising:
a cylindrical case having a bottom and a side wall;
a piezoelectric element having a first main surface and a second main surface, and the second main surface being attached to the bottom inside the case;
a terminal member having a first end disposed inside the case and a second end disposed outside the case;
a strip-shaped flexible printed circuit board that electrically connects the piezoelectric element and the first end of the terminal member;
a first filling material filled in the case so as to cover the bottom; and
a second filling material filled in the case so as to cover the first filling material,
the flexible printed circuit board including:
   a first surface section that has a first electrode electrically connected to the piezoelectric element and extends in contact with the first main surface of the piezoelectric element;
   a second surface section that is bent from an end of the first surface section closer to the side wall of the case, and extends upward along the side wall; and
   a third surface section that has a second electrode electrically connected to the first end of the terminal member, and is bent in an S-shape from an upper end of the second surface section so as to face the first surface section with an interval interposed therebetween,
the first surface section and at least a portion of the second surface section closer to the first surface section being embedded in the first filling material.

### Aspect <2>

The ultrasonic transducer according to aspect <1>, wherein the second surface section is in direct contact with the side wall.

### Aspect <3>

The ultrasonic transducer according to aspect <1> or aspect <2>, wherein the first electrode and the second electrode are disposed on either a front surface or a back surface of the flexible printed circuit board.

### Aspect <4>

The ultrasonic transducer according to any one of aspect <1> to aspect <3>, wherein a ratio of a height of the first filling material to a height of the case in a height direction orthogonal to the bottom is 0.3 or more and 0.7 or less.

### Aspect <5>

The ultrasonic transducer according to any one of aspect <1> to aspect <4>, wherein a curvature of curvature of a portion of the second surface section of the flexible printed circuit board located at a boundary with the end of the first surface section is 0.8 (1/mm) or more and 2.9 (1/mm) or less.

### Aspect <6>

A method of manufacturing an ultrasonic transducer,
the ultrasonic transducer includes:
   a piezoelectric element having a first main surface and a second main surface;
   a cylindrical case having a bottom and a side wall;
   a terminal member having a first end and a second end;
   a strip-shaped flexible printed circuit board having a first electrode and a second electrode and electrically connecting the piezoelectric element and the terminal member to each other;
   a first filling material filled in the case; and
   a second filling material filled in the case,
the method includes:
   connecting the first electrode of the flexible printed circuit board to the first main surface of the piezoelectric element;
   attaching the second main surface of the piezoelectric element connected to the flexible printed circuit board to the bottom, bending the flexible printed circuit board in contact with the side wall, and disposing the second electrode outside the case;
   fixing a portion of the flexible printed circuit board by filling the first filling material in the case so as to cover the bottom;
   connecting the second electrode of the flexible printed circuit board to the first end of the terminal member outside the case;
   disposing the first end of the terminal member connected to the flexible printed circuit board inside the case while leaving the second end of the terminal member outside the case, and bending a portion of the flexible printed circuit board exposed from the first filling material; and
   filling the second filling material in the case so as to cover the first filling material and the bent portion of the flexible printed circuit board exposed from the first filling material.

The components in the embodiments described above may be properly combined.

It should be understood that the embodiments disclosed herein are illustrative and non-restrictive in all respects. The scope of the present invention is defined by the terms of the claims rather than the description of the embodiments above, and is intended to include any modifications within the scope and meaning equivalent to the terms of the claims.

### REFERENCE SIGNS LIST

100, 200: ultrasound transducer; 110: case; 111: bottom; 112: side wall; 120: piezoelectric element; 121: first main surface; 122: second main surface; 130, 230: terminal member; 131: first end; 132: second end; 133: support member; 140, 240: flexible printed circuit board; 141, 241: first surface section; 142, 242: second surface section; 143, 243: third surface section; 145: first electrode; 146, 246: second electrode; 150: first filling material; 160: second filling material; H1, H2: height; R: curvature.

## Claims

1. An ultrasonic transducer comprising:
a cylindrical case having a bottom and a side wall;
a piezoelectric element having a first main surface and a second main surface, and the second main surface being attached to the bottom inside the case;
a terminal member having a first end disposed inside the case and a second end disposed outside the case;
a strip-shaped flexible printed circuit board that electrically connects the piezoelectric element and the first end of the terminal member;
a first filling material filled in the case so as to cover the bottom; and
a second filling material filled in the case so as to cover the first filling material,
the flexible printed circuit board including:
a first surface section that has a first electrode electrically connected to the piezoelectric element and extends in contact with the first main surface of the piezoelectric element;
a second surface section that is bent from an end of the first surface section closer to the side wall of the case, and extends upward along the side wall; and
a third surface section that has a second electrode electrically connected to the first end of the terminal member, and is bent in an S-shape from an upper end of the second surface section so as to face the first surface section with an interval interposed therebetween,
the first surface section and at least a portion of the second surface section closer to the first surface section being embedded in the first filling material.

2. The ultrasound transducer according to claim 1, wherein
the second surface section is in direct contact with the side wall.

3. The ultrasonic transducer according to claim 1 or claim 2, wherein
the first electrode and the second electrode are disposed on either a front surface or a back surface of the flexible printed circuit board.

4. The ultrasonic transducer according to any one of claims 1 to 3, wherein
a ratio of a height of the first filling material to a height of the case in a height direction orthogonal to the bottom is 0.3 or more and 0.7 or less.

5. The ultrasonic transducer according to any one of claims 1 to 4, wherein
in the flexible printed circuit board, a curvature of a curved portion of the second surface section located at a boundary with the end of the first surface section is 0.8 (1/mm) or more and 2.9 (1/mm) or less.

6. A method of manufacturing an ultrasonic transducer,
the ultrasonic transducer including:
a piezoelectric element having a first main surface and a second main surface;
a cylindrical case having a bottom and a side wall;
a terminal member having a first end and a second end;
a strip-shaped flexible printed circuit board having a first electrode and a second electrode and electrically connecting the piezoelectric element and the terminal member to each other;
a first filling material filled in the case; and
a second filling material filled in the case,
the method including:
connecting the first electrode of the flexible printed circuit board to the first main surface of the piezoelectric element;
attaching the second main surface of the piezoelectric element connected to the flexible printed circuit board to the bottom, bending the flexible printed circuit board in contact with the side wall, and disposing the second electrode outside the case;
fixing a portion of the flexible printed circuit board by filling the first filling material in the case so as to cover the bottom;
connecting the second electrode of the flexible printed circuit board to the first end of the terminal member outside the case;
disposing the first end of the terminal member connected to the flexible printed circuit board inside the case while leaving the second end of the terminal member outside the case, and bending a portion of the flexible printed circuit board exposed from the first filling material; and
filling the second filling material in the case so as to cover the first filling material and the bent portion of the flexible printed circuit board exposed from the first filling material.
